Europäisches Patentamt

European Patent Office

Office européen des brevets

(19)

(11) **EP 1 004 166 B1**

(12) **FASCICULE DE BREVET EUROPEEN**

(45) Date de publication et mention
de la délivrance du brevet:
**11.05.2005 Bulletin 2005/19**

(21) Numéro de dépôt: **97935414.9**

(22) Date de dépôt: **22.08.1997**

(51) Int Cl.$^7$: **H03K 17/95**, G01D 3/036

(86) Numéro de dépôt international:
**PCT/CH1997/000312**

(87) Numéro de publication internationale:
**WO 1999/010981 (04.03.1999 Gazette 1999/09)**

(54) **CAPTEUR DE PROXIMITE INDUCTIF A CIRCUIT OSCILLANT A REACTION INDUCTIVE**

**INDUKTIVER NÄHERUNGSSENSOR MIT INDUKTIVE NACHFÜHRUNG AUFWEISENDER OSZILLATORSCHALTUNG**

**INDUCTIVE PROXIMITY SENSOR COMPRISING OSCILLATORY CIRCUIT WITH INDUCTIVE REACTION**

(84) Etats contractants désignés:
**AT BE CH DE ES FR GB IT LI NL SE**

(43) Date de publication de la demande:
**31.05.2000 Bulletin 2000/22**

(73) Titulaire: **Detra SA**
**CH-2502 Bienne (CH)**

(72) Inventeurs:
• **TU, Mai, Xuan**
**CH-1024 Ecublens (CH)**

• **SCHWAB, Michel**
**CH-2502 Bienne (CH)**

(74) Mandataire: **WILLIAM BLANC & CIE**
**Conseils en Propriété Industrielle SA**
**25, Avenue du Pailly**
**1220 Les Avanchets/Genève (CH)**

(56) Documents cités:
| | |
|---|---|
| **CH-B- 655 414** | **DE-A- 3 225 193** |
| **DE-A- 3 312 756** | **DE-A- 3 643 589** |
| **DE-A- 3 919 916** | **DE-A- 4 032 001** |
| **US-A- 4 942 372** | |

Il est rappelé que: Dans un délai de neuf mois à compter de la date de publication de la mention de la délivrance du brevet européen, toute personne peut faire opposition au brevet européen délivré, auprès de l'Office européen des brevets. L'opposition doit être formée par écrit et motivée. Elle n'est réputée formée qu'après paiement de la taxe d'opposition. (Art. 99(1) Convention sur le brevet européen).

## Description

La présente invention a pour objet un capteur de proximité inductif possédant un circuit résonnant constitué par 2 enroulements couplés.

Des capteurs de proximité inductifs utilisant un circuit résonnant sont connus. Voir par exemple US-A-4.942.372. Ces capteurs fonctionnent selon le principe suivant : En l'absence d'un objet métallique à proximité du capteur, le circuit de mesure constitué par un oscillateur travaillant à la résonance oscille à une certaine amplitude dépendant des pertes propres de l'oscillateur (pertes ohmiques dans la bobine du circuit, pertes par hystérésis dans le circuit magnétique de la bobine). La proximité d'un objet métallique provoque des pertes par courants de Foucault induits dans cet objet et par conséquent une diminution de l'amplitude d'oscillation. La comparaison de cette amplitude avec une valeur de référence permet de détecter la présence des objets métalliques.

Le grand inconvénient de ce type de capteur réside dans la sensibilité aux pertes propres du circuit résonnant.

En effet, lors de variations de température, les pertes propres du circuit varient et provoquent une modification de l'amplitude de l'oscillation.

Pour évaluer cette dépendance de température, il existe des méthodes utilisant 2 bobines couplées magnétiquement comme par exemple, les méthodes décrites dans les brevets DE 40 32 001 C2 et CH 655 414 A5. Cependant, la mise en oeuvre de ces méthodes est assez complexe.

Le but de la présente invention est de proposer un nouveau type de capteur, facile à mettre en oeuvre, permettant de remédier aux inconvénients précités.

Ce but est atteint selon la présente invention par un capteur de proximité inductif tel que défini dans la revendication 1.

L'invention sera expliquée en détail dans la description qui va suivre, en se référant aux dessins annexés dans lesquels :

- la figure 1 représente le schéma de principe d'un oscillateur à réaction inductive connu généralement de la technique,

- la figure 2 représente le schéma de principe de l'oscillateur selon l'invention,

- la figure 3 représente un premier exemple de disposition des enroulements primaire et secondaire selon l'invention,

- la figure 4 représente les flux propres et mutuel des enroulements de la figure 3,

- la figure 5 représente un 2ème exemple de disposition des enroulements primaire et secondaire selon l'invention,

- la figure 6 représente un exemple de réalisation du capteur selon l'invention.

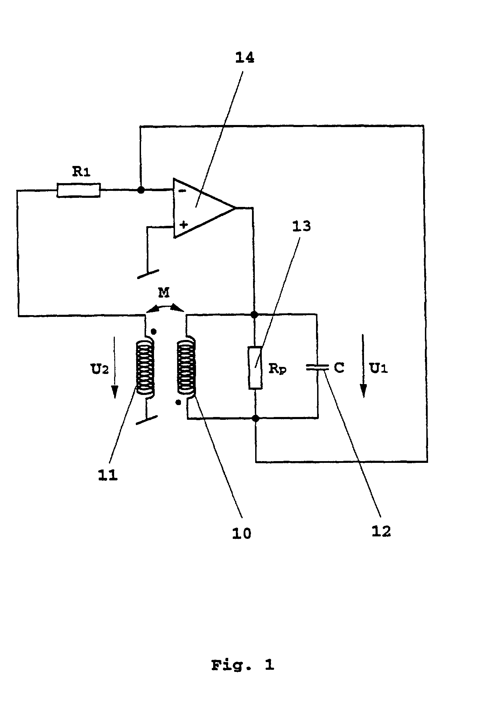

La figure 1 représente le schéma de principe d'un oscillateur à réaction inductive. Cet oscillateur comporte un enroulement primaire 10, aux bornes duquel la capacité 12 est mise en parallèle, la résistance Rp représente la résistance de pertes totales de l'oscillateur comprenant les pertes ohmiques, les pertes par hystérésis et les pertes par courants de Foucault dans le cas où une cible se trouve à proximité. Un enroulement secondaire 11 est couplé avec l'enroulement primaire 10, le couplage entre 2 enroulements étant représenté symboliquement par l'inductance mutuelle M. Une borne de l'enroulement secondaire 11 est mise à la masse, l'autre est reliée à une résistance d'entrée R1 à l'amplificateur 14. Sans la réaction inductive, le gain de l'amplificateur est donné par g = -Rp/R1. Soit k = U2/U1 le rapport des tensions primaire et secondaire sous l'effet du couplage inductif. La condition d'oscillation est donnée par:

$$g \cdot k \geq 1$$

A température constante, en l'absence de la cible, si l'on choisit R1 de façon à ce que g.k soit légèrement supérieur à 1, l'oscillation s'établit.

Lorsque l'on approche d'un objet métallique de l'enroulement primaire, sous l'effet des pertes par courants de Foucault dans la cible, la résistance Rp diminue, ce qui entraîne l'arrêt des oscillations.

Etant donné que Rp dépend aussi des pertes ohmiques et des pertes par hystérésis, on comprend aisément que le fonctionnement d'un capteur utilisant ce circuit n'est pas sûr, sauf si les pertes par courants de Foucault sont beaucoup plus élevées que les pertes propres du circuit. Dans ce cas, il faut que la cible soit très près du capteur, autrement dit le capteur est très peu sensible.

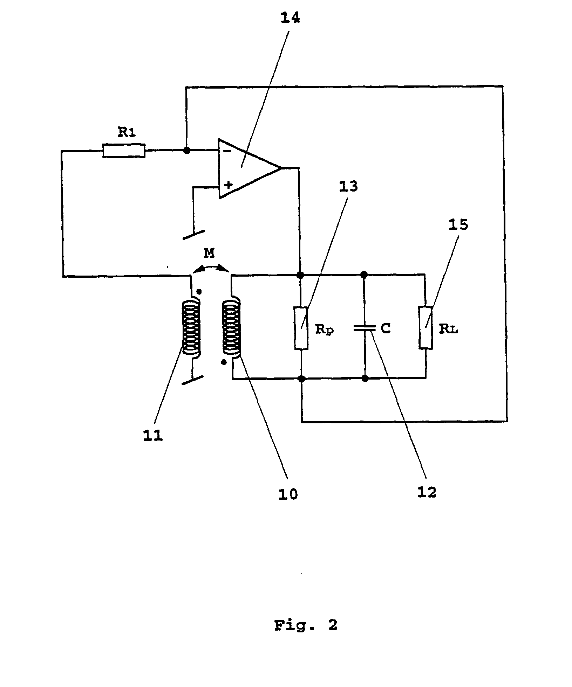

Pour remédier à cet inconvénient, l'invention propose le schéma de la figure 2. Dans ce schéma, on ajoute une résistance de charge RL de valeur sensiblement plus faible que la résistance Rp en l'absence de la cible. De ce fait, lorsque Rp varie en fonction de la température, la résistance équivalente donnée par la mise en parallèle de RL et Rp reste pratiquement constante.

Cependant, en agissant de cette façon, sans prendre de précaution concernant la disposition des enroulements primaire et secondaire, le capteur devient pratiquement insensible car le produit g.k reste pratiquement constant.

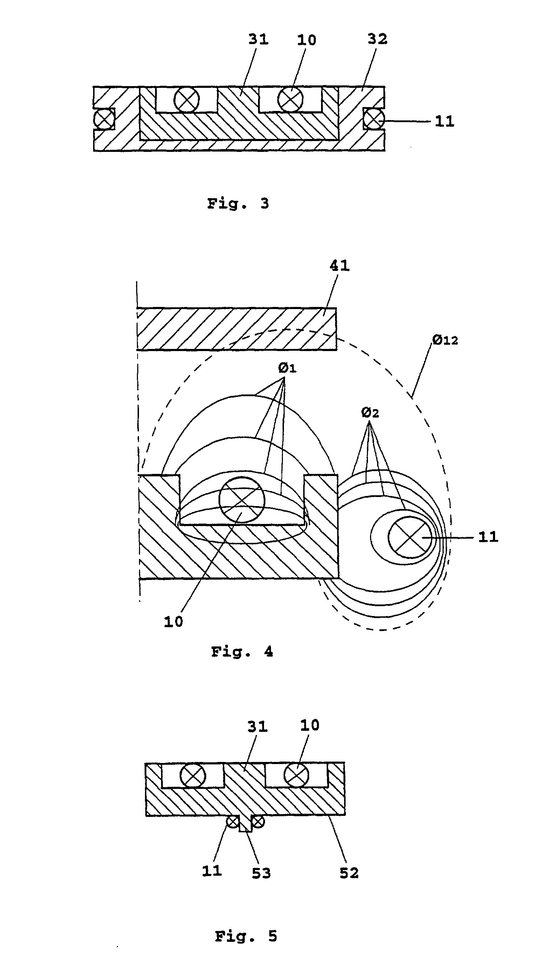

La figure 3 représente un premier exemple de disposition des enroulements primaire et secondaire selon l'invention. L'enroulement primaire 10 est constitué d'une bobine logée dans un pot de ferrite 31. Ce dernier est placé dans une cage en matière isolante faisant aussi office de corps de bobine de l'enroulement secondaire 11.

La figure 4 représente les flux propres et mutuel des enroulements primaire et secondaire de la figure 3. Par cette disposition, le flux propre ø1 de l'enroulement primaire (flux couple seulement avec l'enroulement primaire), ainsi que le flux propre de l'enroulement secondaire ø2 sont sensiblement plus grands que le flux mutuel ø12 entre 2 enroulements. L'approche d'une cible métallique 41 provoque une diminution sensible du couplage ø12 entre 2 enroulements et par conséquent le facteur k. Dans ces conditions, l'oscillateur de la figure 2 s'arrête d'osciller à l'approche d'une cible car le produit g.k est inférieur à 1.

La figure 5 représente un deuxième exemple de disposition des enroulements primaire et secondaire selon l'invention. L'enroulement primaire 10 est constitué par une bobine logée dans un pot de ferrite 31. Sur la face arrière 52, (face opposée à celle exposée à la cible) l'enroulement secondaire 11 est bobiné autour d'une tige en ferrite 53 placée dans l'axe du pot de ferrite 51.

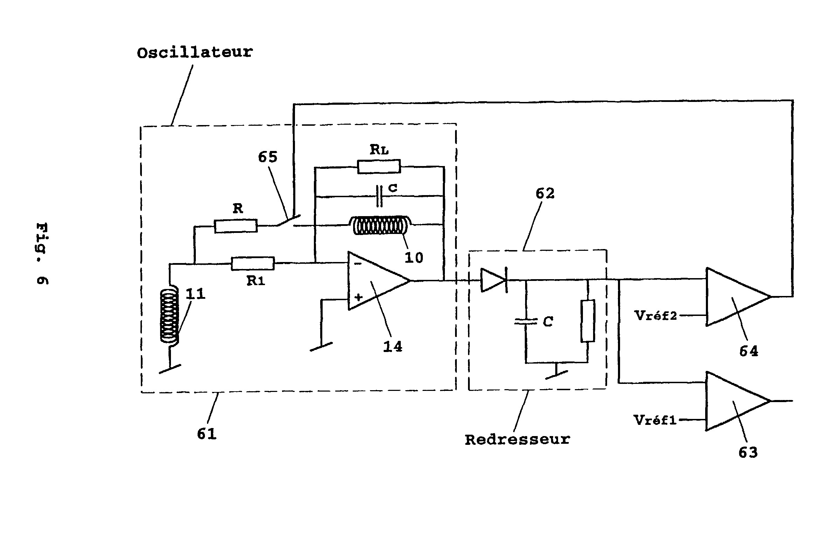

La figure 6 représente un exemple de réalisation d'un capteur selon l'invention. Ce capteur comporte un oscillateur 61, un redresseur 62, un premier comparateur 63 avec une tension de référence Vref1 indiquant la présence ou l'absence de la cible à détecter selon que sa tension d'entrée est plus petite ou plus grande que Vref1 , un deuxième comparateur 64 avec une tension de référence Vref2 < Vref1. La sortie de ce comparateur agit sur l'interrupteur 65 permettant d'augmenter le gain de l'amplificateur 14 lorsque l'amplitude est inférieure à Vref2. Ce circuit permet de maintenir l'oscillation en-dessous de cette tension. De cette façon, on peut améliorer la fréquence de commutation du capteur.

**Revendications**

**1.** Capteur de proximité inductif comprenant un circuit oscillant à réaction inductive, constitué par :

> un amplificateur (14),
> un enroulement primaire (10) relié à une borne de sortie dudit amplificateur,
> un enroulement secondaire (11) relié à une borne d'entrée dudit amplificateur,
> une capacité (12) montée en parallèle sur ledit enroulement primaire,

> **caractérisé en ce qu'**il comprend en outre
> une résistance de charge (15), montée en parallèle sur ledit enroulement primaire, la valeur de ladite résistance de charge étant choisie de façon à ce que, en régime d'oscillations, les pertes ohmiques dans cette résistance soient sensiblement plus élevées que les pertes ohmiques dans l'enroulement primaire,

> et **en ce que**
> les enroulements primaire (10) et secondaire (11) sont disposés de façon à ce que le flux mutuel (Ø 12) entre les 2 enroulements soit sensiblement plus faible que le flux propre de chaque enroulement (Ø 1 ;Ø 2)

**2.** Capteur de proximité inductif selon la revendication 1, **caractérisé par le fait que** ledit enroulement primaire est constitué par une bobine logée dans un pot de ferrite (31), **par le fait que** ledit enroulement secondaire est constitué par une bobine coaxiale avec la première disposée en dehors dudit pot de ferrite et **par le fait que** les enroulements primaire et secondaires se trouvent du même côté par rapport à la cible à détecter.

**3.** Capteur de proximité inductif selon la revendication 2, **caractérisé par le fait que** ledit enroulement secondaire est constitué par une bobine placée sur un corps de bobine en matière isolante (32), disposé autour du pot de ferrite de l'enroulement primaire.

**4.** Capteur de proximité inductif selon la revendication 2, **caractérisé par le fait que** ledit enroulement secondaire est constitué par une bobine enroulée autour d'une tige en ferrite (53) placée sur la face arrière du pot de ferrite de l'enroulement primaire, la face avant du pot étant la face la plus proche de la cible à détecter.

**5.** Capteur de proximité inductif selon l'une des revendications 1 à 4, **caractérisé par le fait qu'**il possède un circuit redresseur (62), un comparateur (63) avec une tension de référence Vref1 indiquant la présence ou l'absence de la cible à détecter, un comparateur (64) avec une tension de référence Vréf2 < Vréf1 dont la sortie est reliée à un circuit de maintien de l'oscillation (65) lequel agit sur le gain de l'amplificateur (14).

**Patentansprüche**

**1.** Induktiver Abstandssensor mit einem induktiven Schwingungskreis, bestehend aus:

> einem Verstärker (14),
> einer an eine Ausgangsklemme des besagten Verstärkers angeschlossenen Primärwicklung (10),
> einer an eine Eingangsklemme des besagten Verstärkers angeschlossenen Sekundärwicklung (11),
> einer zu der besagten Primärwicklung parallel geschalteten Kapazität (12),

**dadurch gekennzeichnet, dass** er weiters umfasst

einen zu der besagten Primärwicklung parallel geschalteten Lastwiderstand (15), wobei der Wert des besagten Lastwiderstands so gewählt ist, dass bei Oszillationsbetrieb die ohmschen Verluste dieses Widerstands etwas größer sind als die ohmschen Verluste in der Primärwicklung,

und dass

die Primär- und Sekundärwicklung (10, 11) so angeordnet sind, dass der gegenseitige Fluss (012) zwischen den 2 Wicklungen etwas geringer ist als der Eigenfluss einer jeden Wicklung (01; 02).

2. Induktiver Abstandssensor nach Anspruch 1, **dadurch gekennzeichnet, dass** die besagte Primärwicklung aus einer in einem Ferrittopf (31) gelagerten Spule besteht, dass die besagte Sekundärwicklung aus einer mit der ersten koaxialen Spule besteht, die außerhalb des besagten Ferrittopfs angeordnet ist, und dass die Primär- und Sekundärwicklung sich auf der gleichen Seite in Bezug auf das zu erfassende Ziel befinden.

3. Induktiver Abstandssensor nach Anspruch 2, **dadurch gekennzeichnet, dass** die besagte Sekundärwicklung aus einer Spule besteht, die auf einem Spulenkörper aus isolierendem Material (32) sitzt, der um den Ferrittopf der Primärwicklung herum angeordnet ist.

4. Induktiver Abstandssensor nach Anspruch 2, **dadurch gekennzeichnet, dass** die besagte Sekundärwicklung aus einer Spule besteht, die um eine Ferritstange (53) gewickelt ist, die sich an der Rückseite des Ferrittopfs der Primärwicklung befindet, wobei die Vorderseite des Topfs die Seite ist, die dem zu erfassenden Ziel am nahesten liegt.

5. Induktiver Abstandssensor nach einem der Ansprüche 1 bis 4, **dadurch gekennzeichnet, dass** er eine Gleichrichterschaltung (62), einen Komparator (63) mit einer Bezugsspannung Vref1, die die An- oder Abwesenheit des zu erfassenden Ziels anzeigt, und einen Komparator (64) mit einer Bezugsspannung Vref2 < Vref1, dessen Ausgang mit einem auf den Faktor des Verstärkers (14) wirkenden Aufrechterhaltungskreis der Oszillation (65) verbunden ist, umfasst.

**Claims**

1. An inductive proximity sensor comprising an inductive-reaction oscillating circuit, consisting of:

an amplifier (14)
a primary winding (10) connected to an output terminal of the said amplifier,
a second winding (11) connected to an input terminal of the said amplifier,
a capacitor (12) connected in parallel to the said primary winding,

**characterised in that** it also comprises

a load resistor (15), connected in parallel to the said primary winding, the value of the said load resistor being chosen so that, in oscillation mode, the ohmic losses in this resistor are substantially higher than the ohmic losses in the primary winding, and **in that**

the primary (10) and secondary (11) windings are disposed so that the mutual flux (0 12) between the two windings is substantially lower than the inherent flux of each winding (0 1; 0 2).

2. An inductive proximity sensor according to Claim 1, **characterised by** the fact that the said primary winding consists of a coil housed in a ferrite pot (31), by the fact that the said secondary winding consists of a coil coaxial with the first disposed outside the said ferrite pot and by the fact that the primary and secondary windings are situated on the same side with respect to the target to be detected.

3. An inductive proximity sensor according to Claim 2, **characterised by** the fact that the said secondary winding consists of a coil placed on a coil body made from insulating material (32), disposed around the ferrite pot of the primary winding.

4. An inductive proximity sensor according to Claim 2, **characterised by** the fact that the said secondary winding consists of a coil wound around a ferrite rod (53) placed on the rear face of the ferrite pot of the primary winding, the front face of the pot being the face closest to the target to be detected.

5. An inductive proximity sensor according to one of Claims 1 to 4, **characterised by** the fact that it has a rectifier circuit (62), a comparator (63) with a reference voltage Vref1 indicating the presence or absence of the target to be detected, and a comparator (64) with a reference voltage Vref2 < Vref1, whose output is connected to a circuit for maintaining the oscillation (65) which acts on the gain of the amplifier (14).

Fig. 1

Fig. 2

Fig. 3

Fig. 4

Fig. 5

Fig. 6